# EUROPEAN PATENT APPLICATION

(11) **EP 4 681 851 A1**
(43) Date of publication of application: **21.01.2026**
(21) Application number: 24189236.3
(22) Date of filing: 17.07.2024
(51) Int. Cl.: B23K 1/008, B23K 1/012, B23K 1/00, B23K 3/08, B23K 101/42

(54) **IMPROVED REFLOW SOLDERING OVEN**

(71) Applicant: Illinois Tool Works Inc., Glenview IL 60025 (US)
(72) Inventor: DIEPSTRATEN, Gerjan, Glenview, 60025 (US)
(74) Representative: HGF

(57) **Abstract**

A reflow soldering oven for soldering an electronic circuit board, the reflow soldering oven comprising: a first temperature control chamber for applying a first temperature profile to the electronic circuit board; a second temperature control chamber for applying a second temperature profile to the electronic circuit board; a vacuum system comprising a vacuum pump and a vacuum chamber for removing voids in a solder on the electronic circuit board, wherein the vacuum chamber is positioned intermediate the first temperature control chamber and the second temperature control chamber and is fluidly connected to the vacuum pump; and a gas purification system for purifying gas that contains flux components vaporized from the electronic circuit board.

## Description

### BACKGROUND

The present invention relates to a reflow soldering oven. More particularly, but not exclusively, the present invention relates to a reflow soldering oven for soldering an electronic circuit board.

During manufacture of printed circuit boards, electronic elements are mounted on the circuit boards generally by means of a process known as "reflow soldering". In a typical reflow soldering process, solder paste (e.g. tin paste) is deposited onto selected areas of a circuit board, and a wire of one or more electronic elements is inserted into the deposited solder paste. The circuit board then passes through a reflow oven in which the soldering paste refluxes (i.e. is heated to a melting or reflux temperature) in a heating area and then cools in a cooling area to form solder joints electrically and mechanically connecting the wires of the electronic components to the circuit board. As used herein, the term "circuit board" comprises a substrate assembly of any type of electronic element, such as comprises a wafer substrate.

During the reflow soldering process, air or gas filled spaces, called voids, can be formed in the solder, for example in the bulk of the solder or at the intermetallic boundaries of the solder joint. Such voids may be caused by trapped flux gases or inadequate wetting of the solder. Larger voids may lead to mechanical weakness, electrical resistance, poor heat dissipation and reliability issues. In high-power electronics, such issues may ultimately result in component failure.

A number of strategies for minimising void formation are known, for example the use of preforms, optimising stencil design, the use of low voiding solder paste. None of these strategies consistently prevents the formation of voids in solder.

Vacuum reflow chambers are used in conjunction with reflow solder ovens to minimize voids during the soldering process by decreasing the pressure and so removing the trapped gases or air. However, contamination, for example caused by solder paste residues, outgasing of solder mask from the board, gases from components or lubrication of the chain, can occur inside the vacuum chamber and affect the vacuum performance. Such contamination can prevent operation of the vacuum chamber and/or the vacuum pump.

There is, therefore, a need to provide a reliable reflow soldering oven that consistently prevents the formation of voids in solder.

### BRIEF SUMMARY

According to an aspect of the invention there is provided a reflow soldering oven for soldering an electronic circuit board, the reflow soldering oven comprising: a vacuum system comprising a vacuum pump and a vacuum chamber for removing voids on the electronic circuit board; and a gas purification system for purifying gas that contains flux components vaporized from the electronic circuit board.

According to another aspect of the invention there is provided a reflow soldering oven for soldering an electronic circuit board, the reflow soldering oven comprising: a first temperature control chamber for applying a first temperature profile to the electronic circuit board; a second temperature control chamber for applying a second temperature profile to the electronic circuit board; a vacuum system comprising a vacuum pump and a vacuum chamber for removing voids in a solder on the electronic circuit board, wherein the vacuum chamber is positioned intermediate the first temperature control chamber and the second temperature control chamber and is fluidly connected to the vacuum pump; and a gas purification system for purifying gas that contains flux components vaporized from the electronic circuit board.

The combination of a vacuum system and a gas purification system ensure a clean reflow process in which voids (in the solder) are minimised or, preferably, eliminated. This beneficially ensures that electronic circuit boards made using the reflow soldering oven are suitable for use in high-power electronics, for which it is necessary to prevent the effects of voids (for example, increased resistance, heat generation and mechanical stress). Further advantageously, the clean process minimises the risk of one or more components of the reflow soldering oven (e.g. the vacuum pump, the vacuum chamber seal, components of the conveyor) malfunctioning or failing.

The gas purification system may include an upstream gas purification unit that is positioned upstream of the vacuum chamber.

The upstream gas purification unit may be positioned intermediate the first temperature control chamber and the vacuum chamber and be configured for purifying air from the first temperature control chamber before it is transferred to the vacuum chamber.

The upstream gas purification unit may therefore purify air from the first temperature control chamber before it is transferred, for example injected, into the vacuum chamber. This prevents contaminants, e.g. flux, from gas, condensing and contaminating the vacuum chamber.

The upstream gas purification unit may be configured to increase the temperature of air from the first temperature control chamber before it is transferred to the vacuum chamber.

The pre-heating of gas before it is transferred to the vacuum chamber minimises the temperature drop following the opening of the vacuum chamber, for example when the electronic circuit board is to be transferred to the second temperature control chamber of the reflow soldering oven.

The upstream gas purification unit may include a gas inlet that is configured to guide gas from the electronic circuit board in the first temperature control chamber to an inner portion of the upstream gas purification unit, and a gas outlet that is configured to guide purified gas to the vacuum chamber.

The upstream gas purification unit may include a catalyst for purifying the gas.

The gas purification system may include a downstream gas purification unit that is positioned downstream of the vacuum chamber.

The downstream gas purification unit may be positioned intermediate the vacuum chamber and the vacuum pump for purifying air from the vacuum chamber before it is transferred to the vacuum pump.

Contamination inside the vacuum chamber (which can be caused by solder paste residues, outgassing of solder mask from the electronic circuit board, gases from components of the electronic circuit board and/or lubrication of the chain and/or other components of the conveyor) are sucked out by the vacuum pump and may condense in the oil of the vacuum pump. Purifying the gas prior to it reaching the vacuum pump, minimises the need to clean the vacuum pump, thereby maximising operational time, and prevents damage being caused to the vacuum pump, which may result in the vacuum pump malfunctioning or failing.

The downstream gas purification unit may include a gas inlet that is configured to guide gas from the electronic circuit board in the vacuum chamber to an inner portion of the downstream gas purification unit, and a gas outlet that is configured to guide purified gas toward the vacuum pump.

The downstream gas purification unit may include a catalyst for purifying the gas.

The vacuum system may include a cooling unit for cooling gas that is transferred from the vacuum chamber to the vacuum pump.

The gas purification unit only works at higher temperatures, so the gas from the vacuum chamber is heated to the required temperature for the catalyst. Cooling the gas from the vacuum chamber before it enters the vacuum pump reduces the risk of the vacuum pump being damaged by the hotter gas.

The vacuum system may include a filter and condensation unit for filtering and condensing gas that is transferred from the vacuum chamber to the vacuum pump.

The filter and condensation unit beneficially ensures that gas is filtered prior to being transferred to the vacuum pump (from the vacuum chamber), thereby improving the efficiency of the vacuum pump.

The first temperature control chamber may be configured to increase the temperature of the electronic circuit board.

The second temperature control chamber may be configured to decrease the temperature of the electronic circuit board.

The reflow soldering oven may include a conveyor, wherein the conveyor is configured to transfer the electronic circuit board from the first temperature control chamber to the vacuum chamber and/or to transfer the electronic circuit board from the vacuum chamber to the second temperature control chamber.

Other technical features may be readily apparent to one skilled in the art from the following figures, descriptions, and claims.

### BRIEF DESCRIPTION OF THE DRAWINGS

Embodiments of the invention will now be described, by way of example only, hereinafter with reference to the accompanying drawings.
FIG. 1 is a schematic representation of a reflow soldering oven in accordance with an embodiment of the present invention;
FIG. 2A is a circuit diagram showing the gas purification system and vacuum system of a reflow soldering oven in accordance with an embodiment of the present invention in a first condition; and
FIG. 2B is a circuit diagram showing the gas purification system and vacuum system of the reflow soldering oven of FIG. 2A in a second condition.

### DETAILED DESCRIPTION

Certain terminology is used in the following description for convenience only and is not limiting. The words 'right', 'left', 'lower', 'upper', 'front', 'rear', 'upward', 'down' and 'downward' designate directions in the drawings to which reference is made and are with respect to the described component when assembled and mounted. The words `inner', `inwardly', `outer' and 'outwardly' refer to directions toward and away from, respectively, a designated centreline or a geometric centre of an element being described (e.g. central axis), the particular meaning being readily apparent from the context of the description.

Further, as used herein, the terms 'connected', 'attached', 'coupled' and 'mounted' are intended to include direct connections between two members without any other members interposed therebetween, as well as, indirect connections between members in which one or more other members are interposed therebetween. The terminology includes the words specifically mentioned above, derivatives thereof, and words of similar import.

Further, unless otherwise specified, the use of ordinal adjectives, such as, "first", "second" and "third" etc. merely indicate that different instances of like objects are being referred to and are not intended to imply that the objects so described must be in a given sequence, either temporally, spatially, in ranking or in any other manner.

Like reference numerals are used to depict like features throughout.

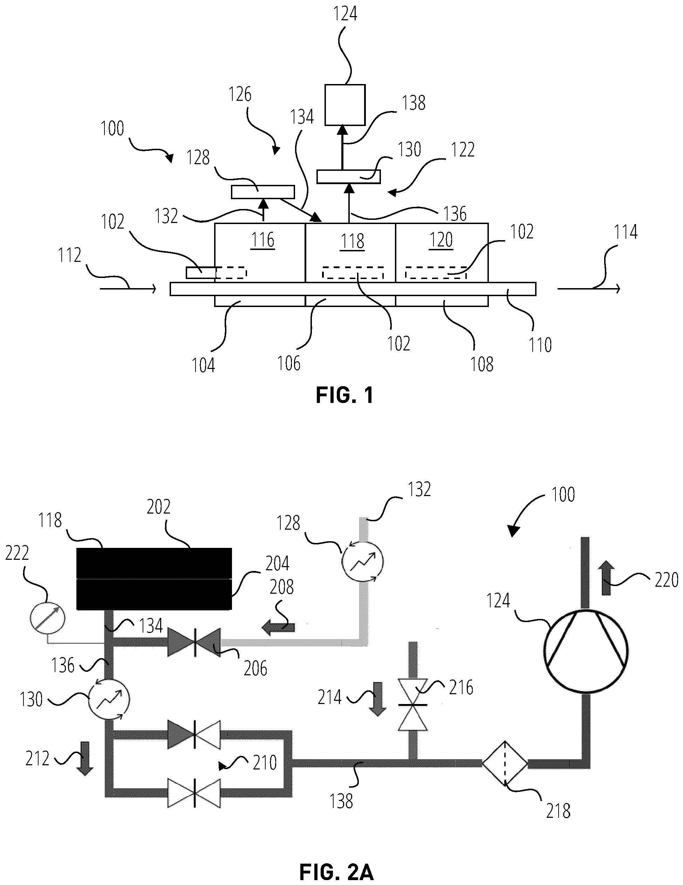

FIG. 1 shows an embodiment of a reflow soldering oven 100 for soldering an electronic circuit board 102 in accordance with the present invention. The reflow soldering oven 100 has a number of zones 104, 106, 108, and a conveyor 110 that is configured to transfer the electronic circuit board 102 from an inlet 112 (shown on the left hand side of the reflow soldering oven 100 in FIG. 1) through each of the zones 104, 106, 108 to an outlet 114 (shown on the right hand side of the reflow soldering oven 100 in FIG. 1).

More than one electronic circuit board 102 may be within the reflow soldering oven 100 at any one time. Each of the electronic circuit boards 102 may be at a different position on the conveyor 110 such that the electronic circuit boards 102 are in different zones 104, 106, 108 of the reflow soldering oven 100.

As shown in FIG. 1, for example, one electronic circuit board 102 may be entering zone 104 from the inlet 112, a second electronic circuit board 102 may be zone 106 and a third electronic circuit board 102 may be in zone 108. In each of the zones 104, 106, 108, the electronic circuit board 102 may be at a different stage in the reflow soldering process.

In the embodiment of FIG. 1, zone 104 is a first temperature control chamber 116, zone 106 is a vacuum chamber 118, and zone 108 is a second temperature control chamber 120.

The first temperature control chamber 116 is configured to apply a first temperature profile to the electronic circuit board 102. The first temperature control chamber 116 may, for example, be configured to increase the temperature of the electronic circuit board 102.

Similarly, the second temperature control chamber 120 is configured to apply a second temperature profile to the electronic circuit board 102. The second temperature control chamber 120 may, for example, be configured to decrease the temperature of the electronic circuit board 102.

The vacuum chamber 118 is part of a vacuum system 122 that also includes a vacuum pump 124. The vacuum system 122 is configured to ensure that voids do not form, or are at least minimised, in the solder on the electronic circuit board 102.

The reflow soldering oven 100 comprises a series of different zones 104, 106, 108. A zone 104, 106, 108 of the reflow soldering oven 100 is an area inside the oven through which the electronic circuit board 102 passes on the conveyor 110. Reflow soldering ovens have multiple such zones that differ from each other with respect to controlled temperature and/or air flow condition for creating a desired temperature / air flow profile during electronic circuit board travel (e.g., for creating along travel a certain preheat time, a soak time, a reflow time and a cooling time).

A zone of the reflow soldering oven is defined by having its own temperature control (e.g. using a zone-dedicated heater) and/or air flow control (e.g. using a zone-dedicated fan and/or zone-dedicated air-flow-determining perforations). The zones are separated from each other by a gap area that has no air flow perforations below and/or underneath the conveyor. In the example shown in FIG. 1, the different zones 104, 106, 108 are arranged in series to each other along a travel direction of the electronic circuit board 102. The electronic circuit board 102 is transferred between the different zones 104, 106, 108 using the conveyor 110.

The reflow soldering oven 100 also includes a gas purification system 126 that is configured to purify gas that contains flux components vaporized from the electronic circuit board 102. The gas purification system 126 includes an upstream gas purification unit 128 and a downstream gas purification unit 130.

The upstream gas purification unit 128 is fluidly connected to each of the first temperature control chamber 116 and the vacuum chamber 118. A first gas inlet 132 is a fluid conduit between the first temperature control chamber 116 and the upstream gas purification unit 128. A first gas outlet 134 is a fluid conduit between the upstream gas purification unit 128 and the vacuum chamber 118.

Similarly, the downstream gas purification unit 130 is fluidly connected to each of the vacuum chamber 118 and the vacuum pump 124. A second gas inlet 136 is a fluid conduit between the vacuum chamber 118 and the downstream gas purification unit 130. A second gas outlet 138 is a fluid conduit between the downstream gas purification unit 130 and the vacuum pump 124.

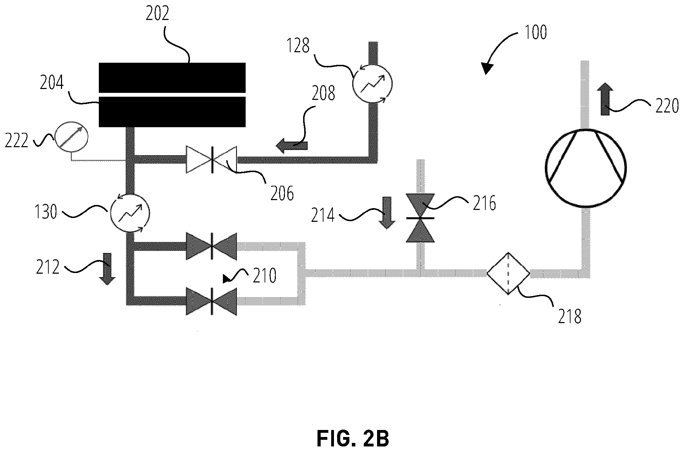

The vacuum system 122 and the gas purification system 126, and their operation in a reflow soldering oven 100 according to the present invention, will now be described with particular reference to FIG. 2A and FIG. 2B.

The vacuum chamber 118 has a first vacuum chamber component 202, in this example an upper vacuum chamber component, and a second vacuum chamber component 204, in this example a lower vacuum chamber component.

The reflow soldering oven 100 includes one or more valve that is configured to control to the flow of a fluid, for example a gas or air, through the first temperature control chamber 116, the gas purification system 126, the vacuum system 122 and/or the second temperature control chamber 120.

A valve 206 may be, for example, positioned between the upstream gas purification unit 128 and the vacuum chamber 118 to control the flow of hot purified gas 208 (gas from the first temperature control chamber 116 that has been purified at the upstream gas purification unit 128) into the vacuum chamber 118.

A valve 210 may be positioned between the downstream gas purification unit 130 and the vacuum pump 124 to control the flow of hot purified gas 212 (gas from the vacuum chamber 118 that has been purified at the downstream gas purification unit 130) into the vacuum pump 124.

To prevent hot gas from the reflow soldering oven 100 causing heat damage to the vacuum pump 124, cool air 214 may be supplied to the second gas outlet 138 (from either the second temperature control chamber 120 or a separate reservoir of cool air) before the hot purified gas 212 is passed through the vacuum pump 124.

A valve 216 may be positioned between the cool air supply and the vacuum pump 124 to control the supply of cool air 214 to the second gas outlet 138.

To prevent contaminants from the cooled gas in the second gas outlet 138 causing damage to the vacuum pump 124, the cooled gas may be passed through a filter and condensation unit 218.

The vacuum pump 124 includes an exhaust, from which exhaust gas 220 may be exhausted to a chamber of the reflow soldering oven 100, for example the second temperature control chamber 120, or to another component of the 100, or to atmosphere.

The reflow soldering oven 100 may also include a pressure sensor 222 that enables an operator is able to monitor the pressure in the vacuum chamber 118 to ensure the pressure of gas in the vacuum chamber 118 is sufficiently low during the vacuum cycle to ensure that any voids in the solder paste are reduced or, preferably, removed.

FIG. 2A shows the vacuum system 122 in a first condition, during a vacuum cycle, in which an electronic circuit board 102 is placed within the vacuum chamber 118. The first vacuum chamber component 202 and the second vacuum chamber component 204 are sealed closed.

In this, first, condition, the valve 206 is closed such that hot purified gas 208 from the first temperature control chamber 116 and upstream gas purification unit 128 cannot be supplied to the vacuum chamber 118.

A vacuum is applied to the vacuum chamber 118 by the vacuum pump 124 which pulls gas from the vacuum chamber 118 through the second gas inlet 136 to the downstream gas purification unit 130. At the downstream gas purification unit 130, the gas from the vacuum chamber 118 is purified. The valve 210 is open and so hot purified gas 212 is able to pass through toward the vacuum pump 124. To prevent, or at least minimise the risk of components of the vacuum pump 124 being damaged by the hot purified gas 212, the valve 216 is opened so that the hot purified gas 212 can be mixed with cool air.

The cooled air is then passed through the filter and condensation unit 218, at which any remaining contaminants (which might cause damage to components and/or reduce the efficiency of the vacuum pump 124) are removed from the cooled air.

The cooled gas is then pumped through the vacuum pump 124 and expelled (either to a chamber of the reflow soldering oven 100 or to atmosphere).

The vacuum system 122 in combination with the gas purification system 126 advantageously enables the formation of voids within solder to be prevented, or at least minimised, during manufacture of an electronic circuit board 102 using the reflow soldering oven 100 of the present invention.

FIG. 2B shows the vacuum system 122 in a second condition, during the vacuum chamber 118 is re-gassed, in preparation for the first vacuum chamber component 202 and the second vacuum chamber component 204 to be opened, and the electronic circuit board 102 to be moved to the next chamber, for example the second temperature control chamber 120, of the reflow soldering oven 100 for the next stage in the reflow soldering process.

In this, second, condition, the valve 206 is open such that hot purified gas 208 from the first temperature control chamber 116 and upstream gas purification unit 128 is supplied to the vacuum chamber 118.

Gas released from the vacuum chamber 118 through the second gas inlet 136 passes through the downstream gas purification unit 130, at which it is purified. The valve 210 is closed and so hot purified gas 212 is not able to pass through toward the vacuum pump 124.

The efficiency of the reflow soldering process is improved by the reflow soldering oven 100 of the present invention since the reflow soldering oven 100 incorporates a gas purification system 126 to prevent contamination of components of the reflow soldering oven 100, including for example components of the vacuum chamber 118, the vacuum pump 124 and/or the conveyor 110, which might result in the need for maintenance, repair or replacement of the affected components of the reflow soldering oven 100, resulting in machine downtime.

Once the electronic circuit board 102 is removed from the vacuum chamber 118 and conveyed to the next chamber in the reflow soldering oven 100, a further electronic circuit board 102 may be transferred to the vacuum chamber 118 and the steps described in relation to FIG. 2A and FIG. 2B repeated. The upstream gas purification unit 128 that is upstream of the vacuum chamber 118 prevents gas condensing in or contaminating the vacuum chamber 118. The gas is also preheated due to the purification process, which minimize the temperature drop after opening the vacuum chamber to release the electronic circuit board. In this way, the reflow soldering oven 100 of the present invention can be used for high throughput, as well as high quality, production of electronic circuit boards.

As referred to herein, gas may be air or a specific inert gas or inert gas mixture used inside the reflow soldering oven, like for example nitrogen. If gas flow is mentioned, this stands for both, air flow or gas flow, depending on the type of gas in the oven.

A gas purification unit 128, 130 according the present invention, may be a gas purification unit as described in European patent application published as EP053691. The gas purification unit may include cleaning means configured to clean gas according to one or a combination of the following cleaning principles: catalytic cleaning, cleaning by condensation of vaporized flux components on a condenser within the gas purification unit. A condenser is preferably a component or area inside the gas purification unit featuring a surface area equipped with cooling means, for condensing vapor on that surface area. Each gas purification unit may additionally comprise a particle filter, e.g. a metal or paper filter, after a catalyst.

Each of the at least two gas purification units 128, 130 comprises a gas inlet, an inner portion and a gas outlet. The gas inlet is configured to guide gas from the electronic circuit board inside the reflow soldering oven 100 to the inner portion of the gas purification unit 128, 130. The inner portion being inside the gas purification unit 128, 130, e.g. the catalyst material. The gas outlet is configured to guide cleaned gas from the inner portion of the gas purification unit 128, 130, e.g. from the catalyst material, back to the inside of the reflow soldering oven 100, for example a chamber within the reflow soldering oven 100, or to the outside of the reflow soldering oven 100.

Each of the gas purification units 128, 130 define an air/gas cycle or a part of such cycle forcing gas through the gas purification unit, e.g. through the catalyst material of the respective gas purification unit. At least one or each of the gas purification units 128, 130 may further comprise means for controlling the air flow (actively: e.g., a fan; and/or passively: e.g., a predetermined or adjustable orifice) and/or a heating element, for heating the gas to a temperature optimized or adapted for the cleaning, e.g. for a catalysis with a catalyst material.

One gas purification unit is at least partially directing cleaned gas from its inside, e.g. from its catalyst material, further into another of the at least two gas purification units. The first gas purification unit is thereby serving as a pre-filter. The second gas purification unit is taking in gas not only from the first gas purification unit, but also from at least one different zone of the oven and/or even yet another gas purification unit; hence, the second gas purification unit is merging at least two different air flows. The gas purification units can be arranged inside the oven or outside the oven using a suitable air/gas duct system.

A zone of the reflow soldering oven is an area inside the oven and the circuit board to be soldered is travelling through the zone. Preferably, it is an area that is being controlled to remain at a stable temperature and/or air flow condition. Usually, a reflow soldering oven has multiple such zones that differ from each other with respect to controlled temperature and/or air flow condition for creating a desired temperature / air flow profile along circuit board travel (e.g., for creating along travel a certain preheat time, a soak time, a reflow time and cooling time). Particularly preferably, a zone of the reflow soldering oven is defined by having its own temperature control (e.g. using a zone-dedicated heater) and/or air flow control (e.g. using a zone-dedicated fan and/or zone-dedicated air-flow-determining perforations). Preferably, the zones are separated from each other by a gap area that has no air flow perforations below and/or underneath the circuit board travel.

The at least two gas purification units being dedicated to different zones may be understood as one gas purification unit being dedicated to one specific zone or group of zones and the other gas purification unit being dedicated to a different zone or a different group of zones. A different group of zones is present, if the one group differs in at least one zone present or not present compared to the other zone or group of zones. Preferably, dedicated to zones further means that at least 75%, preferably at least 90% of gas being directed into the dedicated gas purification unit originates from the zone or group of zones the gas purification unit is dedicated to. For example, a gas purification unit has an air flow at the intake of 100 volume-units per minute (whereas, for example, gas in each zone is circulating with an air flow of 1000 volume-units per minute), at least 75 volume-units per minute are originating from the zone, to which the gas purification is unit dedicated, and less than 25 volume-units per minute are originating from somewhere else, e.g. a neighboring zone.

At least two of the different zones are arranged in series to each other along a travel direction of the electronic circuit board.

The gas purification units are dedicated to different zones along circuit board travel direction. Variations in vapor are expected especially along travel direction as the temperature / air flow profile is changing in this direction, and therefore, gas purification units can be advantageously adapted to the variations in vapor.

In series to each other along a travel direction of the electronic circuit board may preferably be understood as an arrangement of the at least two zones where the circuit board, when travelling through the oven, is passing at first through one of these zones and then through the other of these zones.

At least two gas purification units may differ from each other in at least one of the following:
- an air flow through the gas purification unit;
- an amount of heating or cooling down the gas (preferably within the gas purification unit);
- an amount of particle filtering (preferably within the gas purification unit);
- a cleaning principle or combination of cleaning principles realized by the gas purification unit, wherein a cleaning principle is one of the following: catalytic cleaning, cleaning by condensation of vaporized flux components on a condenser within the gas purification unit. In a further preferred method according to the invention, air flow through and/or heating or cooling by the at least two gas purification units is controlled differently and/or different amounts of particle filtering or different cleaning principles or combination of cleaning principles are accordingly used.

The cleaning performance of the gas purification units can be adapted to the locally different cleaning needs advantageously and in a flexible way.

The air flow through the gas purification unit dedicated to a zone, in which a high vaporization due to the soldering process is present (e.g., a zone corresponding at least partly to the reflow phase of the solder process), is set or controlled to a higher level than the air flow through the different gas purification unit dedicated to a zone, in which a low or lower vaporization due to the soldering process is present (e.g., a zone corresponding at least partly to the soak phase of the soldering process). Preferably, different air flows in different gas purification units are achieved by differently configured means for controlling the air flow (actively: e.g., a fan; and/or passively: e.g., a predetermined or adjustable orifice). Hereby, the different air flow conditions through the different gas purification units compensate for the locally different vaporization in the oven.

The amount of heating the gas by a gas purification unit dedicated to a zone, in which a high temperature due to the soldering process is present (e.g., a zone corresponding at least partly to the reflow phase of the solder process), is set or controlled to a lower level (or even zero) than the amount of heating of the gas by a different gas purification unit dedicated to a zone, in which a low or lower temperature due to the soldering process is present (e.g., a zone corresponding at least partly to the soak phase of the soldering process). Preferably, different amounts of heating of the gas in different gas purification units are achieved by differently configured means for controlling the heating or by the absence of heating in one gas purification unit whereas heating is present in another gas purification unit. The different heating makes use of the locally different temperature in the oven. Heating is only done where needed and hence, energy consumption is lowered.

In the case the gas purification unit has a condenser for purifying the gas, the amount of cooling the gas by a gas purification unit dedicated to a zone, in which a high temperature due to the soldering process is present (e.g., a zone corresponding at least partly to the reflow phase of the solder process), is set or controlled to a higher level than the amount of cooling of the gas by a different gas purification unit dedicated to a zone, in which a low or lower temperature due to the soldering process is present (e.g., a zone corresponding at least partly to the soak phase of the soldering process). Preferably, different amounts of cooling of the gas in different gas purification units are achieved by differently configured means for controlling the cooling (e.g., differently sized or controlled condensers) or by the absence of cooling in one gas purification unit whereas cooling is present in another gas purification unit. The different cooling makes use of the locally different temperature in the oven. Preferably, the amount of particle filtering in a zone with higher occurrence of particles within the gas is higher than in a zone with lower occurrence of particles. E.g. the filter density or number of layers of a particle filter is higher for resulting in a higher amount of particle filtering wherein the filter density or number of layers of a particle filter is lower for resulting in a lower amount of particle filtering; alternatively, a particle filter is present in one gas purification unit and not present in another gas purification unit.

One gas purification unit of the at least two gas purification units is setup for catalyst cleaning (i.e. comprising a catalyst unit comprising a catalyst material) and another gas purification unit of the at least two gas purification units is set up for cleaning by condensation.

The different adaptation methods (air flow, heating, cooling, particle filtering, cleaning principle) may be combined with each other, influencing each other's necessary/advantageous amount of adaption of the gas purification unit to the dedicated zone. This has become possible by this invention because different gas purification units are dedicated to different zones.

One of the at least two gas purification units comprises a catalyst unit comprising a catalyst material.

The gas purification can be performed well at a higher temperature level. This is, depending on the usual process temperature inside the zone, to which the gas purification unit is dedicated, more efficient than cooling down the gas by the condenser.

The catalyst material may contain an oxidation catalyst. Preferably, the catalyst material is arranged according to a honeycomb structure. It may alternatively have a bead structure (e.g., ceramic catalyst balls) or plate structure.

At least one of the at least two gas purification units comprises a catalyst unit comprising a catalyst material, such that the oven comprises at least two catalyst units, and the at least two catalyst units differ from each other in at least one of the following:
- the chemical composition and/or a geometrical structure of the catalyst material,
- an air flow through the catalyst material,
- an amount of preheating of the gas before impinging on the catalyst material,
- an amount of particle filtering before and/or after the catalyst material. In a further preferred method according to the invention, air flow and/or preheating through the at least two catalyst units is controlled differently and/or a different chemical composition and/or geometrical structure of the catalyst material and/or different particle filtering is used.

The cleaning performance of the catalyst units can be adapted to the locally different cleaning needs advantageously and in a flexible way.

The chemical composition of the catalyst material of a catalyst unit dedicated to a zone, in which a high temperature due to the soldering process is present (e.g., a zone corresponding at least partly to the reflow phase of the process), features a higher optimal catalyst reaction temperature than the chemical composition of a catalyst material of a different catalyst unit dedicated to a zone, in which a low or lower temperature due to the soldering process is present (e.g., a zone corresponding at least partly to the soak phase of the soldering process). Hereby, the catalyst material is advantageously adapted to temperatures present due to the soldering process and therefore, the cleaning is efficient and the amount of necessary preheating is lower or even not necessary (e.g. in cleaning of zones where a low temperature is present and the catalyst material is adapted to this lower temperature). The chemical composition of the catalyst material compensates for the soldering-process-determined temperature differences within the oven.

The geometrical structure of the catalyst material is chosen from honeycomb structure, bead structure and plate structure to adapt to locally different needs.

Criterions of the choice may be one or more of the following: the ease of exchange or recyclability (if the catalyst is exhausted), the needed or preset air flow through the material, the price, the lifetime given the locally present vaporization within the dedicated zone, the resulting dimensions of the catalyst.

The air flow through the catalyst material of a catalyst unit dedicated to a zone, in which a high vaporization due to the soldering process is present (e.g., a zone corresponding at least partly to the reflow phase of the solder process), is set or controlled to a higher level than the air flow through the catalyst material of a different catalyst unit dedicated to a zone, in which a low or lower vaporization due to the soldering process is present (e.g., a zone corresponding at least partly to the soak phase of the soldering process). Preferably, different air flows in different catalyst units are achieved by differently configured means for controlling the air flow (actively: e.g., a fan; and/or passively: e.g., a predetermined or adjustable orifice). Hereby, the different air flow conditions through the catalyst materials of different catalyst units compensate for the locally different vaporization in the oven.

The amount of preheating of the gas by a catalyst unit dedicated to a zone, in which a high temperature due to the soldering process is present (e.g., a zone corresponding at least partly to the reflow phase of the solder process), is set or controlled to a lower level (or even zero) than the amount of preheating of the gas by a different catalyst unit dedicated to a zone, in which a low or lower temperature due to the soldering process is present (e.g., a zone corresponding at least partly to the soak phase of the soldering process). Preferably, different amounts of preheating of the gas in different catalyst units are achieved by differently configured means for controlling the preheating or by the absence of preheating in one catalyst unit whereas preheating is present in another catalyst unit. The different preheating makes use of the locally different temperature in the oven. Preheating is only done where needed and hence, energy consumption is lowered.

The different amount of particle filtering has already been described above and is applicable here as well.

The different adaptation methods (chemical composition, geometrical structure, air flow, preheating, particle filtering) may be combined with each other and with those described above for general gas purification units, influencing each other's necessary/advantageous amount of adaption of the catalyst unit to the dedicated zone. This has become possible by this invention because different catalyst units are dedicated to different zones.

At least two of the gas purification units are equipped with a diagnostic system configured to measure an efficiency of the respective gas purification unit. In a further preferred method according to the present invention the efficiencies of at least two of the gas purification units are measured.

The different efficiency states of different gas purification units can be comfortably monitored. The efficiency is indicating the contamination state of the gas purification unit, e.g. the contamination state of a catalyst material, making it not necessary to exchange all gas purification units at once but only those that are exhausted. This enhances comfort and costs when using different gas purification units. A diagnostic system is for example a measurement of gas pressure or chemical component (e.g., glycol ethers) concentration before and after the cleaning medium (e.g. catalyst material or condenser), hence a pressure drop measurement or chemical component difference measurement, and if the pressure drop is getting too high (e.g. exceeds a threshold) or the chemical component difference is getting too low the diagnostic system signalizes it. The diagnostic system may also work instead or additionally with absolute values of pressure/chemical component concentration.

The combination of a vacuum system and a gas purification system ensure a clean reflow process in which voids (in the solder) are minimised or, preferably, eliminated. This beneficially ensures that electronic circuit boards made using the reflow soldering oven are suitable for use in high-power electronics, for which it is necessary to prevent the effects of voids (for example, increased resistance, heat generation and mechanical stress). Further advantageously, the clean process minimises the risk of one or more components of the reflow soldering oven (e.g. the vacuum pump, the vacuum chamber seal, components of the conveyor) malfunctioning or failing.

In the described example, the gas purification system includes an upstream gas purification unit 128 and a downstream gas purification unit 130. In particular, the upstream gas purification unit 128 of the described embodiment is positioned between a first temperature control chamber 116 and a vacuum chamber 118 of the reflow soldering oven 100 and the downstream gas purification unit 130 of the described embodiment is positioned between the vacuum chamber 118 and the vacuum pump 124 of the vacuum system 122.

It will be appreciated that, in alternative examples of the invention, the gas purification system may include a single gas purification unit, which may be associated with one of the temperature control chambers of the reflow soldering oven. Alternatively, the gas purification system may include a gas purification unit that is associated with one, some or all of the temperature control chambers of the reflow soldering oven. In a further alternative example of the invention, the gas purification system may include a single gas purification unit, which may be associated with the vacuum system. As in the example described above, the gas purification unit may be positioned between the vacuum chamber and a valve. In alternative examples of the invention, the gas purification system may be positioned between the valve and a cool air inlet, or between a cool air inlet and a filter and condensation unit, or between a filter and condensation unit and the vacuum pump.

It will be appreciated by persons skilled in the art that the above detailed examples have been described by way of example only and not in any limitative sense, and that various alterations and modifications are possible without departing from the scope of the invention as defined by the appended claims. Various modifications to the detailed examples described above are possible.

Through the description and claims of this specification, the words "comprise" and "contain" and variations of them mean "including but not limited to", and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics, compounds, chemical moieties or groups described in conjunction with a particular aspect, embodiment or example of the invention are to be understood to be applicable to any other aspect, embodiment or example described herein unless incompatible therewith. All of the features disclosed in this specification (including any accompanying claims, abstract and drawings), and/or all of the steps of any method or process so disclosed, may be combined in any combination, except combinations where at least some of such features and/or steps are mutually exclusive. The invention is not restricted to the details of any foregoing embodiments. The invention extends to any novel one, or any novel combination, of the features disclosed in this specification (including any accompanying claims, abstract or drawings), or to any novel one, or any novel combination, of the steps of any method or process so disclosed.

### LIST OF FEATURES

| | | | |
|---|---|---|---|
| 100 | Reflow soldering oven | 202 | First vacuum chamber component |
| 102 | Electronic circuit board | 204 | Second vacuum chamber component |
| 104 | Zone | 206 | Valve |
| 106 | Zone | 208 | Hot purified gas |
| 108 | Zone | 210 | valve |
| 110 | Conveyor | 212 | Hot purified gas |
| 112 | Inlet | 214 | Cool air |
| 114 | Outlet | 216 | Valve |
| 116 | First temperature control chamber | 218 | Filter and condensation unit |
| 118 | Vacuum chamber | 220 | Exhaust gas |
| 120 | Second temperature control chamber | 222 | Pressure sensor |
| 122 | Vacuum system | | |
| 124 | Vacuum pump | | |
| 126 | Gas purification system | | |
| 128 | Upstream gas purification unit | | |
| 130 | Downstream gas purification unit | | |
| 132 | First gas inlet | | |
| 134 | First gas outlet | | |
| 136 | Second gas inlet | | |
| 138 | Second gas outlet | | |

## Claims

1. A reflow soldering oven for soldering an electronic circuit board, the reflow soldering oven comprising:
a first temperature control chamber for applying a first temperature profile to the electronic circuit board;
a second temperature control chamber for applying a second temperature profile to the electronic circuit board;
a vacuum system comprising a vacuum pump and a vacuum chamber for removing voids in a solder on the electronic circuit board, wherein the vacuum chamber is positioned intermediate the first temperature control chamber and the second temperature control chamber and is fluidly connected to the vacuum pump; and
a gas purification system for purifying gas that contains flux components vaporized from the electronic circuit board.

2. The reflow soldering oven according to claim 1, wherein the gas purification system comprises an upstream gas purification unit that is positioned upstream of the vacuum chamber.

3. The reflow soldering oven according to claim 2, wherein the upstream gas purification unit is positioned intermediate the first temperature control chamber and the vacuum chamber for purifying air from the first temperature control chamber before it is transferred to the vacuum chamber.

4. The reflow soldering oven according to claim 2 or 3, wherein the upstream gas purification unit is configured to increase the temperature of air from the first temperature control chamber before it is transferred to the vacuum chamber.

5. The reflow soldering oven according to claim 2, claim 3 or claim 4, wherein the upstream gas purification unit comprises a gas inlet that is configured to guide gas from the electronic circuit board in the first temperature control chamber to an inner portion of the upstream gas purification unit, and a gas outlet that is configured to guide purified gas to the vacuum chamber.

6. The reflow soldering oven according to any one of claims 2 to 5, wherein the upstream gas purification unit comprises a catalyst for purifying the gas.

7. The reflow soldering oven according to any one of claims 1 to 6, wherein the gas purification system comprises a downstream gas purification unit that is positioned downstream of the vacuum chamber.

8. The reflow soldering oven according to claim 7, wherein the downstream gas purification unit is positioned intermediate the vacuum chamber and the vacuum pump for purifying air from the vacuum chamber before it is transferred to the vacuum pump.

9. The reflow soldering oven according to claim 7 or 8, wherein the downstream gas purification unit comprises a gas inlet that is configured to guide gas from the electronic circuit board in the vacuum chamber to an inner portion of the downstream gas purification unit, and a gas outlet that is configured to guide purified gas toward the vacuum pump.

10. The reflow soldering oven according to any one of claims 7 to 9, wherein the downstream gas purification unit comprises a catalyst for purifying the gas.

11. The reflow soldering oven according to any one of claims 1 to 10, wherein the vacuum system comprises a cooling unit for cooling gas that is transferred from the vacuum chamber to the vacuum pump.

12. The reflow soldering oven according to any one of claims 1 to 11, wherein the vacuum system comprises a filter and condensation unit for filtering and condensing gas that is transferred from the vacuum chamber to the vacuum pump .

13. The reflow soldering oven according to any one of claims 1 to 12, wherein the first temperature control chamber is configured to increase the temperature of the electronic circuit board.

14. The reflow soldering oven according to any one of claims 1 to 13, wherein the second temperature control chamber is configured to decrease the temperature of the electronic circuit board.

15. The reflow soldering oven according to any one of claims 1 to 14, comprising a conveyor, wherein the conveyor is configured to transfer the electronic circuit board from the first temperature control chamber to the vacuum chamber and/or to transfer the electronic circuit board from the vacuum chamber to the second temperature control chamber.
